# EUROPEAN PATENT APPLICATION

(11) **EP 3 955 290 A1**
(43) Date of publication of application: **16.02.2022**
(21) Application number: 20191121.1
(22) Date of filing: 14.08.2020
(51) Int. Cl.: H01L 25/07, H01L 25/18, H01L 25/00, H02M 7/487, H01L 23/48, H01L 23/00, H02M 7/00, H01L 27/02, H01L 25/11

(54) **SWITCH DEVICE AND METHOD FOR MANUFACTURING THE SWITCH DEVICE**

(71) Applicant: Infineon Technologies AG, 85579 Neubiberg (DE)
(72) Inventor: MÜLLER, Christian Robert, 97421 Schweinfurt (DE); COLVERO SCHITTLER, Andressa, 59494 Soest (DE)
(74) Representative: Sticht, Andreas

(57) **Abstract**

A switch device is described including a first transistor switch and a second transistor switch. Each of the first and second transistor switches comprises a plurality of submodules. At least one submodule of the first transistor switch is spatially arranged closer to at least two submodules of the second transistor switch than to other submodules of the first transistor switch.

## Description

In power semiconductor switch devices nowadays in a variety of applications like solar cell rectifiers or motor drivers topologies are used which use three or more input voltages which, by switching switches of the switch device, may be selectively coupled to an output or several outputs. Examples include neutral point clamp topologies (NPC) like NPC1 or NPC2 and active neutral point clamp topologies (ANPC) like ANPC1, ANPC2 or ANPC3.

Such switch devices include a plurality of switches implemented by one or more transistors. Depending on implementations, switches of such a switch device may be required to have different properties. For example, some switches may be designed for low switching losses (also referred to as fast switches), while other switches may be optimized for low conduction losses (also referred to as slow switches). For low losses in such switch devices, depending on the switch device various criteria have to be fulfilled. These may include placing load terminals close to each other, optimizing commutation paths by a low number of bond wires leading to parasitic stray inductances, equal current distribution and optimized heat spreading.

In view thereof, there is a need for optimized layouts in such switch devices.

### SUMMARY

A switch device as defined in claim 1 and a method as defined in claim 13 are provided. The dependent claims define further embodiments.

In an embodiment, a switch device is provided, comprising:
a plurality of transistor switches including a first transistor switch and at least one second transistor switch, wherein the first transistor switch includes a plurality of first submodules, each first submodules including one or more first transistors of the first transistor switch,
wherein the at least one second transistor switch includes a plurality of second submodules, each second submodule including one or more second transistors of the at least one second transistor switch, and
wherein at least one of the first submodules is spatially arranged such that it is closer to at least two of the second submodules than to other first submodules than the at least one of the first submodules.

In another embodiment, a method for manufacturing a switch device is provided, comprising:
providing a plurality of transistor switches including a first transistor switch and at least one second transistor switch,
wherein the first transistor switch includes a plurality of first submodules, each first submodule including one or more first transistors of the first transistor switch, wherein the at least one second transistor switch includes a plurality of second submodules, each second submodule including one or more second transistors of the at least one second transistor switch, and
spatially arranging at least one of the first submodules such that it is closer to at least two of the second submodules than to other first submodules than the at least one of the first submodules.

The above summary is merely a brief overview over some embodiments and is not to be construed as limiting, as other embodiments may include other features than the ones explicitly given above.

### BRIEF DESCRIPTION OF THE DRAWINGS

Fig. 1 is a schematic top view of a switch device according to an embodiment.
Fig. 2 is a schematic top view of a switch device according to a comparative example.
Fig. 3 is a schematic top view of a switch device according to an embodiment.
Fig. 4 is a schematic top view of a switch device according to a comparative example.
Fig. 5 is a schematic top view of a switch device according to an embodiment.
Fig. 6 is a schematic top view of a switch device according to a comparative example.
Fig. 7 is a schematic top view of a switch device according to an embodiment.
Fig. 8 is a schematic view of a layout of a switch device according to an embodiment.
Figs. 9 to 11 illustrate various switch device topologies which may be implemented using various embodiments.
Fig. 12 is a flowchart illustrating a method according to an embodiment.

### DETAILED DESCRIPTION

In the following, various embodiments will be described in detail referring to the attached drawings. These embodiments are given by way of example only and are not to be construed as limiting.

Features from different embodiments may be combined to form further embodiments. Variations and modifications described with respect to one of the embodiments are also applicable to other embodiments and therefore are not described repeatedly.

Besides features or elements explicitly shown and described, also conventional features or elements, for example features or elements used in conventional switch devices, may be provided.

Any directional terminology used when referring to the drawings like up, down, left, right, top, bottom etc. are used for easy reference to parts in the drawings and is not to be construed as indicating a direction where implementations of the switch devices shown have to be arranged in space, as they may be placed in arbitrary directions.

In the following, various embodiments of switch devices are discussed. A switch device typically comprises a plurality (i.e. two or more) transistor switches, which may be controlled to selectively couple one or more inputs of the switch device to one or more outputs of the switch device. A switch device may for example include one or more transistor switches integrated on different chips and/or in different modules or one or more transistor switches integrated on a single chip.

Individual transistor switches of such a switch device may include a plurality (i.e. two or more) transistors. For example, for high current applications, a plurality of transistors may be coupled in parallel, such that each transistor of the transistor switch carries only part of the current, or, in case of high voltage applications, may be coupled in series such that a total voltage drop may be divided between the individual transistors.

Transistor switches and individual transistors are described as having two load terminals and a control terminal herein. The control terminal serves to switch the transistor switch or transistor on or off. In an on-state, the transistor switch or transistor provides a low-ohmic connection between its load terminals (the resistance in this case is often referred to as on-resistance Ron), and in an off-state essentially provides an electric isolation between its load terminals (apart from possible small leakage currents, depending on design).

Various types of transistors may be used to implement transistor switches, for example field effect transistors like MOSFETs, bipolar junction transistors (BJTs), insulated gate bipolar transistors (IGBTs) or reverse conducting devices (RCDs) like RC-IGBTs. In case of field effect transistors, the above-mentioned load terminals correspond to the source and drain terminals, and the control terminal corresponds to the gate terminal. In case of a bipolar junction transistor, the load terminals correspond to the collector and emitter terminals, and the control terminal corresponds to the base terminal. In case of insulated gate bipolar transistors, the load terminals correspond to the collector and emitter terminals, and the control terminal corresponds to the gate terminal. In the following embodiments described with respect to the figures, field effect transistors are used as examples, but it is to be understood that also other types of transistors may be used.

Various semiconductor materials may be used for implementing transistors, for example silicon (Si), silicon carbide (SiC), or gallium nitride (GaN). Different transistors or transistor switches in a switch device may be of the same type of transistor and/or based on the same semiconductor material, but may also be of different transistor types and/or based on different semiconductor materials.

When a transistor switch includes a plurality of transistors as discussed above, these transistors are commonly controlled, i.e. they are switched on and off jointly, and as mentioned, the load terminals of the transistors are either connected in parallel or in series to sustain higher currents or voltages.

The transistors forming a transistor switch may be partitioned into a plurality of submodules. Each submodule then may include one or more transistors. The individual submodules may be integrated on a single chip, while different submodules may be provided on different chips. In other embodiments, different submodules may be provided in different regions of the same chip.

In embodiments discussed in the following a switch device includes a first transistor switch and at least one second transistor switch. The first transistor switch includes a plurality of first submodules, and the at least one second transistor switch includes a plurality of second submodules. At least one of the first submodules may be spatially arranged such that it is closer to at least two of the second submodules than to other first submodules than the at least one of the first submodule. "Closer to" may indicate that a shortest distance between the at least one of the first submodules and the at least two of the second submodules or a distance between centers of the at least one of the first submodules and the at least two of the second submodules is smaller than a corresponding distance (shortest distance or center distance) between the at least one of the first submodules and other first submodules. In some embodiments, it may indicate that between the at least two of the second submodules and the at least one of the first submodules, no other submodules can be placed. It should be noted that other first submodules than the at least one of the first submodules, for example a first submodule at a periphery of an arrangement of the first and second submodules, may be closer to only at least one of the second submodules than to others of the first submodules, or may be arranged in another manner. In some embodiments, each of the first submodules may be closer to at least one of the second submodules than to other first submodules. It should further be noted that arrangements may also include more than one second transistor switch. As an example, the at least one second transistor switch may include two second transistor switches. In this case, e.g. submodules of different second transistor switches may be positioned closer to the at least one of the first submodules than the other ones of the first submodules. Various examples of such arrangements will now be discussed referring to the figures together with comparative examples.

In the following examples, two transistor switches each including two submodules are used. However, the same arrangements discussed may also be used for more transistor switches, or transistor switches including more submodules. Moreover, in embodiments discussed below the two transistor switches are coupled in parallel, and also the submodules are coupled in parallel, using the same source and drain electrodes, but different gate electrodes. Such arrangements may be used to implement a single switch in a switch device topology like NPC or ANPC topologies. In other embodiments, the two transistor switches may be electrically coupled in other manners.

It should also be noted that for implementing submodules of a transistor switch, or implementing a transistor switch, different types of transistors or the same type of transistors may be used. For example, in some implementations, all transistors in a submodule may be of the same type, whereas in other implementations they may be of different types. In some implementations, all submodules of a transistor switch include the same type of transistor, whereas in other cases, they may include different types of transistors.

In the following description of the figures, like elements are denoted with the same reference numerals and will therefore not be described in detail repeatedly.

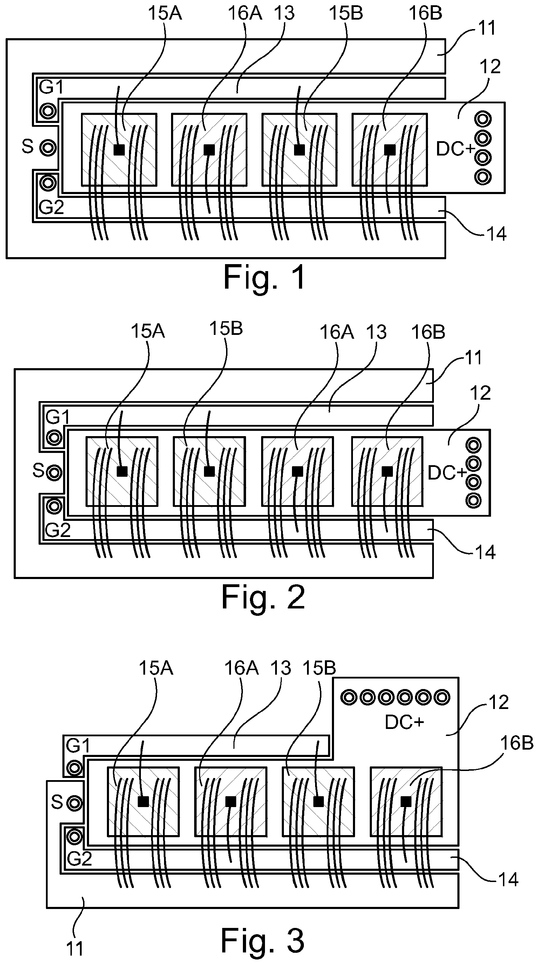

Fig. 1 illustrates a top view of a switch device according to an embodiment. The switch device includes a first transistor switch having submodules 15A and 15B, and a second transistor switch including submodules 16A and 16B. Each submodule 15A, 15B, 16A, 16B may include one or more transistors, field effect transistors in the present example case. The submodules 15A, 15B, 16A, 16B are represented as squares. A drain terminal of each submodule is on a bottom side (not visible in the top view of Fig. 1), a source terminal is provided over a top side (visible in Fig. 1), and a respective gate terminal is represented as a small square in the middle of each submodule. This representation is to be taken as schematic only. For example, other placements of gate, source and drain terminals are also possible.

The transistor switches are provided to selectively couple a drain electrode 12, which may be coupled to a positive DC voltage via contacts DC+, to a source electrode 11, which is contacted at a contact denoted S. The first transistor switch is controlled via a gate electrode 13, which may be connected to some control circuitry via a contact G1, and the second transistor switch is controlled via a gate electrode 14, which may be coupled to control circuitry via contact G2.

As shown, the gate terminals of first submodules 15A, 15B are coupled via respective bond wires with gate electrode 13, and also the gate terminals of second submodules 16A, 16B are coupled to gate electrode 14 via respective bond wires. Therefore, the first and second transistor switches may be switched independently via the respective gate electrodes 13, 14, but the submodules of the same transistor switch device are switched together.

The source terminals of the submodules 15A, 15B, 16A and 16B are coupled to source electrode 11 via bond wires as shown, and the drain terminals of the submodules are mounted to drain electrode 12, for example using conductive solder or other conductive mounting techniques. The number of bond wires shown in Fig. 1 is only an example, and is not to be construed as limiting in any way. With the form of the electrodes in Fig. 1, an inductive negative feedback coupling of the source is provided. In other embodiments, for example separate source terminals 11 for the first and second submodules may be provided.

The above explanations regarding the submodules and their connection to electrodes 11, 12, 13 and 14 also applies to the Figs. 2 to 7 below and therefore will not be repeated for each Figure.

In Fig. 1 current generally flows from the right side (DC+) to the left side (S).

In Fig. 1, the submodules 15A, 15B of the first transistor switch and the submodules 16A, 16B of the second transistor switch are provided in an alternating manner, e.g. between the first submodules 15A, 15B of the first transistor switch is submodule 16A of the second transistor switch is provided, and vice versa. Therefore, for example first submodule 15B is closer to both second submodules 16A, 16B than to the other first submodule 15A.

Fig. 2 shows a comparative example to better explain properties of the embodiment of Fig. 1. In Fig. 2, first submodules 15A, 15B are arranged adjacent to each other, and second submodules 16A, 16B are arranged adjacent to each other. Therefore, for example first submodule 15B in this case is as close to second submodule 16A as it is to first submodule 15A, and further away from second submodule 16B.

In some embodiments, the arrangement of Fig. 1 has the following advantages:
When both transistor switches are switched on by corresponding signals provided via gate terminals 13, 14, submodules arranged more to the right in Figs. 1 and 2 tend to carry more current than submodules arranged closer to the left, as they are closer to the DC+ contacts supplying current. Therefore, in Fig. 1 submodule 16B tends to carry more current than submodule 15B, which tends to carry more current than submodule 16A, which in turn tends to carry more current than submodule 15A. In Fig. 2, second submodules 16A, 16B carry more current than first submodules 15A, 15B. In other words, in this case both submodules of the second transistor switch carry more current than the submodules of the first transistor switch.

From this, it can be seen, that the alternating arrangement of the submodules of the first and second transistor switches in Fig. 1 helps to balance the current between the first and second transistor switches better. Therefore, in some implementations, a current flow may be better balanced between transistor switches. It should be noted that remaining differences in current distribution between the transistor switches may be reduced or compensated by modifying control of the submodules, for example by using different gate resistances for each transistor switch. Furthermore, in Fig. 1 the current may be better distributed over an available area in some implementations. For example, the current coming from the right side in Fig. 1 which is intended to flow through submodule 16A when submodules 16A, 16B are switched on is distributed over a larger part of electrode 12 than in case of Fig. 2. This may lead to reduced stray inductances in some implementations.

Furthermore, if only the first transistor switch with submodules 15A and 15B is switched on and the second transistor switch with submodules 16A and 16B is switched off or vice versa (second transistor switch switched on and first transistor switch switched off), the submodules which are switched on are spaced further apart in case of Fig. 1 than in case of Fig. 2. This, in some implementations, may facilitate heat dissipation, and then generally the alternating arrangement may help to ensure a similar thermal behavior for both the first and second transistor switches.

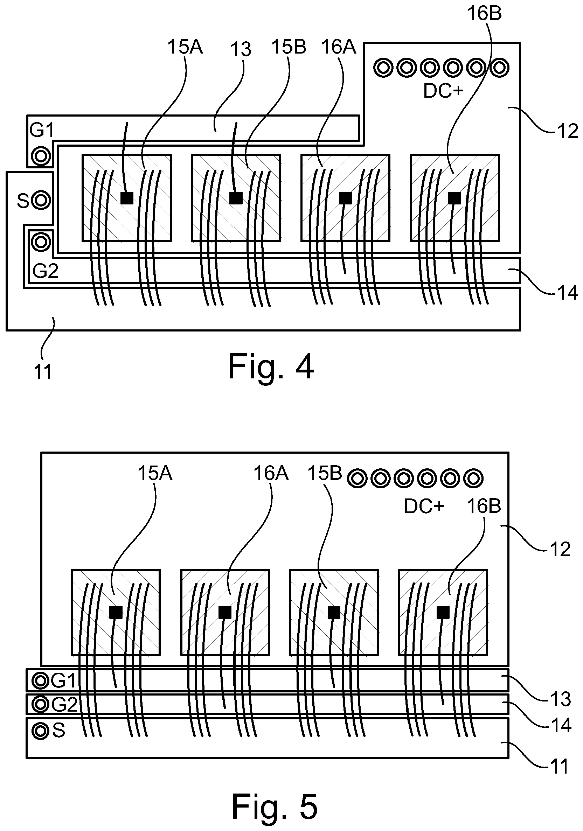

Fig. 3 shows a switch device according to a further embodiment. In the embodiment of Fig. 3, current flows from the upper right (DC+) to the left. Otherwise, the embodiment of Fig. 3 corresponds to the embodiment of Fig. 1, with submodules 15A, 15B of a first transistor switch and submodules 16A, 16B of a second transistor switch being arranged in an alternating manner. Fig. 4 shows a corresponding comparative example, where first submodules 15A, 15B are arranged next to each other, and second submodules 16A, 16B are also arranged next to each other. Also here, in some implementations in the comparative example of Fig. 4, a more inhomogeneous distribution of current occurs when both transistor switches are switched on compared to Fig. 3, and moreover, when only one transistor switch is switched on, in some implementations the heat dissipation is improved in Fig. 3 compared to Fig. 4.

Fig. 5 illustrates a switch device according to a further embodiment. Here, the source electrode 11 is provided at the bottom of the switch device, so that current essentially flows from the upper right (contact DC+) to the lower left (contact S). In the embodiment of Fig. 5, again the submodules 15A, 15B of the first transistor switch and the submodules 16A, 16B of the second transistor switch are arranged in an alternating manner.

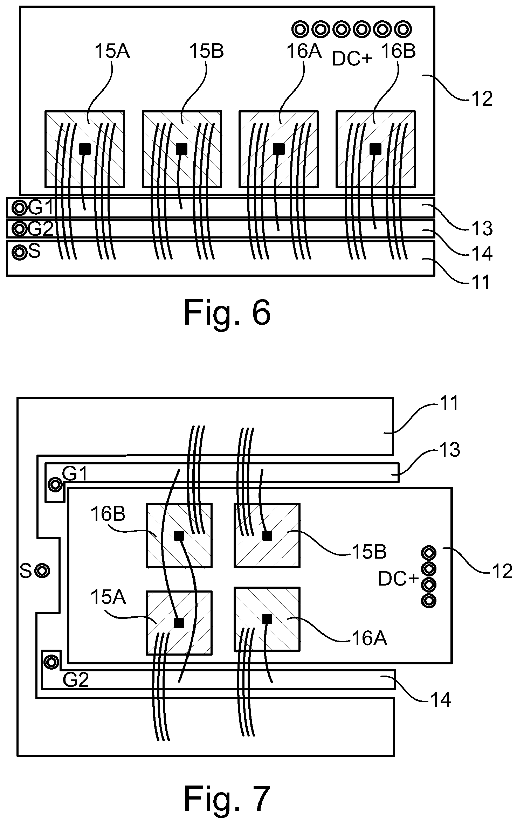

Fig. 6 shows a corresponding comparative example, where switch modules 15A, 15B are arranged adjacent to each other, and switch modules 16A, 16B are also arranged adjacent to each other.

Also in this case, the embodiment of Fig. 5 in some implementations may provide a better current distribution than the comparative example of Fig. 6, and in case only one of the transistor switches is switched on, the embodiment of Fig. 5 may provide better heat dissipation than the reference example of Fig. 6.

In the embodiments of Figs. 1, 3 and 5, submodules were arranged in a linear fashion adjacent to each other. Other arrangements are also possible. For instance, as an example, Fig. 7 illustrates a switch device according to an embodiment, with an arrangement of electrodes 11 to 14 similar to the one of Fig. 1. However, in this case, submodules 15A, 15B, 16A, 16B are arranged in two dimensions in a chessboard fashion. Also in this case, for example submodules 16B, 16A are closer to submodule 15A than submodule 15B. For example, the distances between the centers (for example gate electrodes) of the submodules are shorter between submodule 15A and submodule 16B and submodule 15A and submodule 16A than the distance between submodule 15A and submodule 15B.

Also in this case, in some implementations a more uniform current distribution and better heat dissipation than in the reference example of Fig. 2 may be achieved.

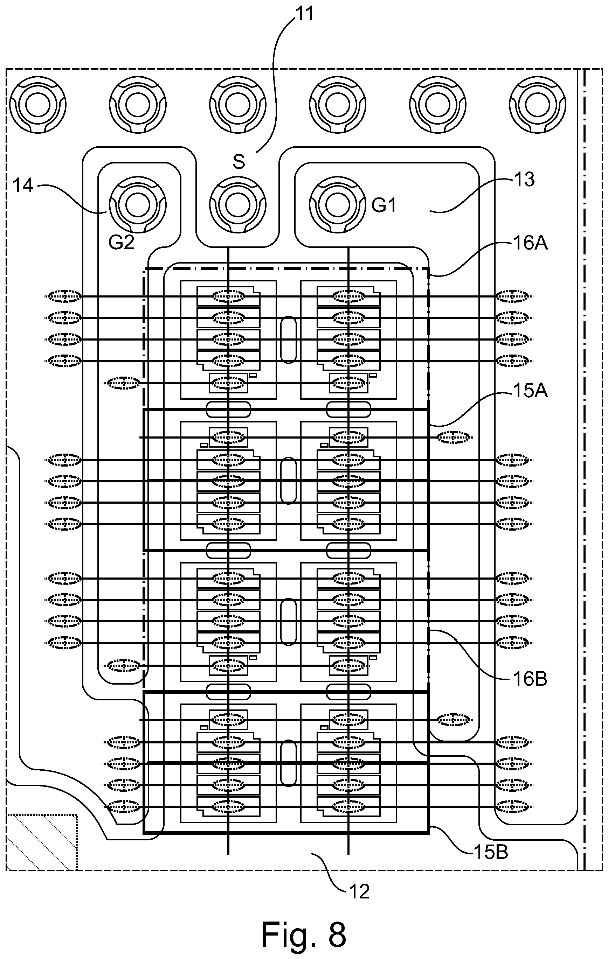

Fig. 8 shows a layout example for such an embodiment corresponding to the embodiment of Fig. 1. Here, submodules 16A, 15A, 16B and 15B are arranged in an alternating manner, and each submodule includes two transistors. Compared to Fig. 1, here bondwires to source are more evenly distributed than in Fig. 1 (in Fig. 1 only downwards from submodules 15A, 15B, 16A, 16B, in Fig. 8 both to the left and right sides), which in some implementations may help to reduce stray inductances.

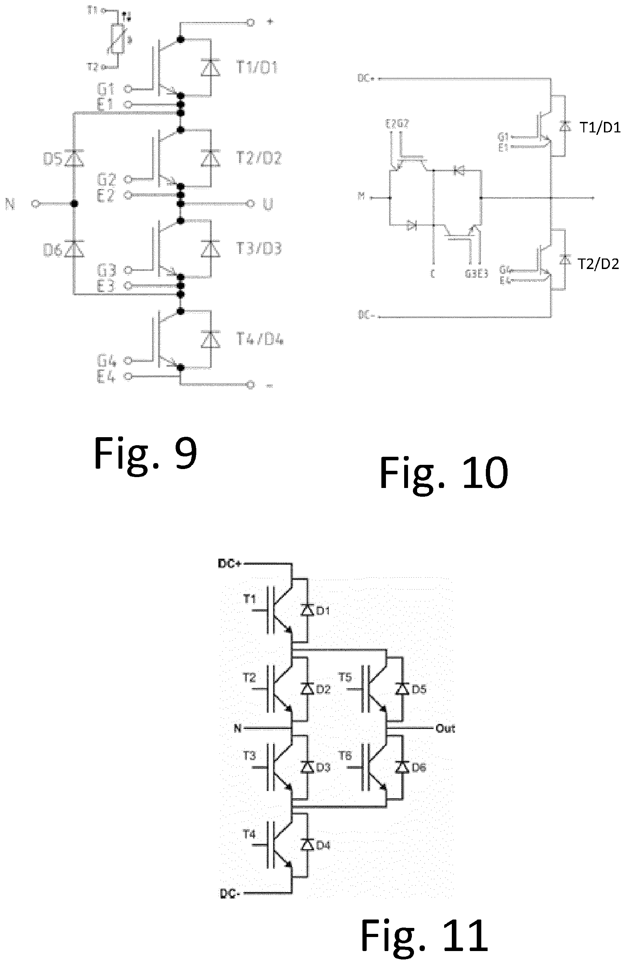

Switch devices, as discussed herein, may be used in various switch device topologies. To give some examples, Fig. 9 illustrates a neutral point clamp (NPC)1 topology, with four switches T1 to T4, Fig. 10 shows an NPC2 topology with four switches T1 to T4 and Fig. 11 shows an active neutral point clamp topology (ANPC) with six switches T1 to T6. Switches T1 to T6 are represented as field effect transistors together with diodes D1 to D6 herein.

In some implementations, each of switches T1 to T6 in Figs. 9 to 11 may be implemented as discussed with reference to Figs. 1 to 8, i.e. as including two or more transistor switches, each having submodules arranged as for example in Figs. 1, 3, 5 or 7. In other embodiments, two or more switches of T1 to T6 may be implemented with submodules arranged as shown. For example, T1 may be made of two or more submodules, and T2 may be made of two or more submodules, which are arranged as discussed above (with drain/source connections modified compared to Figs. 1, 3, 5 and 7 to reflect the different connections of the switches). Also, in some implementations, some of the switches T1 to T6 may be implemented as discussed herein, whereas other switches may be implemented in a conventional manner. As the topologies of Figs. 9 to 11 are per se conventional topologies, they will not be discussed in detail. In contrast to conventional implementations, however, in Figs. 9 to 11, according to embodiments, some or all of the switches are implemented using the techniques discussed above.

The decision which switches are implemented using techniques discussed herein may be made or are based on the properties of the switches. Further, for optimizing the layout of such topologies, as well as dimensioning of the switches and choice of transistors for the switches, it is helpful to identify main commutation paths for different current and voltage conditions, as along these paths, the most important switching of switches happens. In other words, depending on the operation, some switches are switched more often, while other switches may keep their state (on or off) during at least most of the operation.

For example, for the ANPC topology of Fig. 11, various modulation principles are possible. In the so-called ANPC1 approach, T1 to T4 are fast switches and T5 and T6 are slow switches. In the ANPC2 topology, T5 and T6 are fast switches and T1 to T4 are slow switches. Different switches may be provided on different substrates. For example, in an ANPC1 topology, T1, D1, T2, D2 and T5, D5 may be implemented on one substrate, and T3/D3, T4/D4 and T6/D6 may be implemented on another substrate, with corresponding submodules.

In some embodiments, for an ANPC1 topology, T1 and T4 may be implemented as discussed above e.g. with respect to Figs. 1, 3, 5 or 7, for example using silicon carbide MOSFETs, to have a symmetric current distribution. By providing separate gate electrodes as discussed above, an adaptation of the switching speed may be possible. The remaining switches (T2, T3, T5, T6) may be realized in a conventional manner, for example using silicon IGBTs. Different switches may be designed for different voltages for loss optimization. This may allow the operation without synchronous rectification, as the body diodes of SiC MOSFETs is not stressed when commuting.

As this example shows, different types of transistors and implementations may be mixed in a topology.

The use of a plurality of transistor switches with separate gates for a single switch of a given topologies like the one in Figs. 9 to 11, may enable different operation strategies. For example a current dependent operation may be made, where for load current only one of the transistor switches is active, while the other transistor switch is off. When the load current (current between drain and source) reaches a predefined level, both transistor switches are switched simultaneously. This may help to decrease device temperature and may help to avoid thermal overload.

In other embodiments, a parallel operation of both transistor switches of a switch device may be used, where all submodules have been in the same switching state. By providing separate gates, an adaptation of the switching speed for different transistor switches may be provided, which may compensate asymmetries in the gate or asymmetries through an inductive negative feedback.

Also, in other embodiments, an interleaved operation is possible, i.e. the transistor switches are used in an alternating manner for switching.

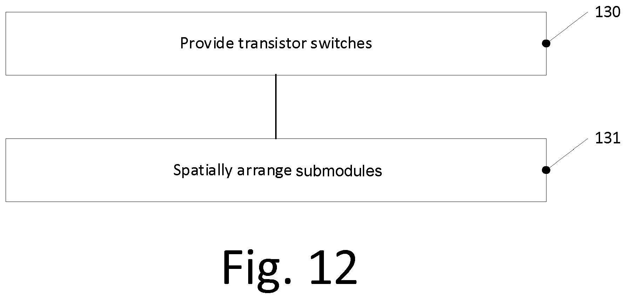

Fig. 12 is a flowchart illustrating a method for manufacturing a switch device according to an embodiment, which may be used to manufacture switch devices as discussed above with reference to Figs. 1 to 11 or other similar switch devices. In order to avoid repetitions, the method of Fig. 12 will be explained referring to the previous explanations.

At 130, the method includes providing transistor switches, each transistor switch comprising submodules, as explained above.

At 131, the method comprises spatially arranging the submodules as explained above, i.e. such that at least one submodule of one of the transistor switches is closer to at least two submodules of another one of the transistor switches than to further submodules of the one transistor switch.

Some embodiments are defined by the following examples:
Example 1. A switch device, comprising:
   a plurality of transistor switches including a first transistor switch and at least one second transistor switch,
   wherein the first transistor switch includes a plurality of first submodules, each first submodule including one or more first transistors of the first transistor switch, wherein the at least one second transistor switch includes a plurality of second submodules, each second submodule including one or more second transistors of the at least one second transistor switch, and
   wherein at least one of the first submodules is spatially arranged such that it is closer to at least two of the second submodules than to other first submodules than the at least one of the first submodules.
Example 2. The switch device of example 1, wherein the at least one of the first submodules is arranged spatially between the at least two of the second submodules.
Example 3. The switch device of example 2, wherein the first and second submodules are spatially arranged in a first direction in an alternating manner.
Example 4. The switch device of example 3, wherein the first transistor switch and the at least one second transistor switch are arranged to switch a current flow in the first direction.
Example 5. The switch device of example 3, wherein the first transistor switch and the at least one second transistor switch are arranged to switch a current flow in a second direction different from the first direction.
Example 6. The switch device of example 5, wherein the second direction is essentially perpendicular to the first direction.
Example 7. The switch device of example 1, wherein the plurality of first submodules and the plurality of second submodules are spatially arranged in an alternating manner in a first direction and in a second direction perpendicular to the first direction.
Example 8. The switch device of any one of examples 1 to 7, wherein the plurality of transistor switches further comprises at least one third transistor switch including a plurality of third submodules, each third submodule including one or more third transistors of the third transistor switch, wherein the first, second and third submodules are spatially arranged in an alternating manner in at least one direction.
Example 9. The switch device of any one of examples 1 to 8, wherein the switch device includes at least three inputs and at least one output.
Example 10. The switch device of example 9, wherein the plurality of transistor switches are arranged in a topology selected from the group consisting of a neutral point clamped, NPC, and an active neutral point clamped, ANPC, topology.
Example 11. The switch device of any one of examples 1 to 10, wherein a first load terminal of the first transistor switch is coupled to a first load terminal of the at least one second transistor switch, a second load terminal of the first transistor switch is coupled to a second load terminal of the at least one second transistor switch, and a control terminal of the first transistor switch is controllable separately from a control terminal of the at least one second transistor switch.
Example 12. The switch device of any one of examples 1 to 11, wherein each of the first submodules is closer to at least one of the second submodules than to other first submodules than the respective first submodule.
Example 13. A method for manufacturing a switch device, comprising:
   providing a plurality of transistor switches including a first transistor switch and at least one second transistor switch,
   wherein the first transistor switch includes a plurality of first submodules, each first submodule (15A, 15B) including one or more first transistors of the first transistor switch,
   wherein the at least one second transistor switch includes a plurality of second submodules, each second submodule including one or more second transistors of the at least one second transistor switch, and
   spatially arranging at least one of the first submodules such that it is closer to at least two of the second submodules than to other first submodules than the at least one of the first submodules.
Example 14. The method of example 13, wherein the method is configured to manufacture the switch device of any one of examples 1 to 12.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A switch device, comprising:
a plurality of transistor switches including a first transistor switch and at least one second transistor switch,
wherein the first transistor switch includes a plurality of first submodules (15A, 15B), each first submodule (15A, 15B) including one or more first transistors of the first transistor switch,
wherein the at least one second transistor switch includes a plurality of second submodules (16A, 16B), each second submodule (16A, 16B) including one or more second transistors of the at least one second transistor switch, and
wherein at least one of the first submodules (15A, 15B) is spatially arranged such that it is closer to at least two of the second submodules (16A, 16B) than to other first submodules (15A, 15B) than the at least one of the first submodules (15A, 15B).

2. The switch device of claim 1, wherein the at least one of the first submodules (15A, 15B) is arranged spatially between the at least two of the second submodules (16A, 16B) .

3. The switch device of claim 2, wherein the first and second submodules (15A, 15B, 16A, 16B) are spatially arranged in a first direction in an alternating manner.

4. The switch device of claim 3, wherein the first transistor switch and the at least one second transistor switch are arranged to switch a current flow in the first direction.

5. The switch device of claim 3, wherein the first transistor switch and the at least one second transistor switch are arranged to switch a current flow in a second direction different from the first direction.

6. The switch device of claim 5, wherein the second direction is essentially perpendicular to the first direction.

7. The switch device of claim 1, wherein the plurality of first submodules (15A, 15B) and the plurality of second submodules (16A, 16B) are spatially arranged in an alternating manner in a first direction and in a second direction perpendicular to the first direction.

8. The switch device of any one of claims 1 to 7, wherein the plurality of transistor switches further comprises at least one third transistor switch including a plurality of third submodules, each third submodule including one or more third transistors of the third transistor switch, wherein the first, second and third submodules (15A, 15B, 16A, 16B) are spatially arranged in an alternating manner in at least one direction.

9. The switch device of any one of claims 1 to 8, wherein the switch device includes at least three inputs and at least one output.

10. The switch device of claim 9, wherein the plurality of transistor switches are arranged in a topology selected from the group consisting of a neutral point clamped, NPC, and an active neutral point clamped, ANPC, topology.

11. The switch device of any one of claims 1 to 10, wherein a first load terminal of the first transistor switch is coupled to a first load terminal of the at least one second transistor switch, a second load terminal of the first transistor switch is coupled to a second load terminal of the at least one second transistor switch, and a control terminal of the first transistor switch is controllable separately from a control terminal of the at least one second transistor switch.

12. The switch device of any one of claims 1 to 11, wherein each of the first submodules (15A, 15B) is closer to at least one of the second submodules (16A, 16B) than to other first submodules than the respective first submodule (15A, 15B) .

13. A method for manufacturing a switch device, comprising:
providing a plurality of transistor switches including a first transistor switch and at least one second transistor switch,
wherein the first transistor switch includes a plurality of first submodules (15A, 15B), each first submodule (15A, 15B) including one or more first transistors of the first transistor switch,
wherein the at least one second transistor switch includes a plurality of second submodules (16A, 16B), each second submodule including one or more second transistors of the at least one second transistor switch, and
spatially arranging at least one of the first submodules (15A, 15B) such that it is closer to at least two of the second submodules (16A, 16B) than to other first submodules (15A, 15B) than the at least one of the first submodules (15A, 15B).

14. The method of claim 13, wherein the method is configured to manufacture the switch device of any one of claims 1 to 12.
